# EUROPÄISCHE PATENTSCHRIFT

(11) **EP 1 497 481 B1**
(45) Veröffentlichungstag und Bekanntmachung des Hinweises auf die Patenterteilung: **17.06.2015**
(21) Anmeldenummer: 03725039.6
(22) Anmeldetag: 16.04.2003
(51) Int. Cl.: C23C 16/455

(54) **Verfahren zum Abscheiden dünner Schichten auf einem Substrat in einer höhenverstellbaren Prozesskammer**
Method for depositing thin layers on a substrate in a height-adjustable process chamber
Procédé de dépôt des fines couches sur un substrat dans une chambre de traitement variable en hauteur

(30) Priorität: 22.04.2002 DE 10217806
(43) Veröffentlichungstag der Anmeldung: 19.01.2005
(73) Patentinhaber: Aixtron SE, 52134 Herzogenrath (DE)
(72) Erfinder: JÜRGENSEN, Holger, 52072 Aachen (DE); STRAUCH, Gerhard, Karl, 52072 Aachen (DE)
(74) Vertreter: Grundmann, Dirk
(86) Internationale Anmeldenummer: PCT/EP2003/003953
(87) Internationale Veröffentlichungsnummer: WO 2003/089684

(56) Entgegenhaltungen:
- WO-A-93/17448
- WO-A1-02/084726
- US-A- 5 443 647
- CHUNG W Y ET AL: "Modelling of Cu thin film growth by MOCVD process in a vertical reactor" JOURNAL OF CRYSTAL GROWTH, NORTH-HOLLAND PUBLISHING CO. AMSTERDAM, NL, Bd. 180, Nr. 3-4, 1. Oktober 1997 (1997-10-01), Seiten 691-697, XP004113956 ISSN: 0022-0248
- VERNON S M ET AL: "Close-spaced MOCVD reactor for 1%-uniformity growth of In-containing materials on 4 substrates" PROCEEDINGS OF THE INTERNATIONAL CONFERENCE ON INDIUM PHOSPHIDE AND RELATED MATERIALS. SANTA BARBARA, MAR. 27 - 31, 1994, NEW YORK, IEEE, US, Bd. CONF. 6, 27. März 1994 (1994-03-27), Seiten 137-140, XP010119022 ISBN: 0-7803-1476-X
- VAN DER STRICHT W ET AL: "Study of GaN and InGaN films grown by metalorganic chemical vapour deposition" JOURNAL OF CRYSTAL GROWTH, NORTH-HOLLAND PUBLISHING CO. AMSTERDAM, NL, Bd. 170, Nr. 1-4, 1997, Seiten 344-348, XP004087131 ISSN: 0022-0248
- KIM I ET AL: "Growth of InGaAsP in a stagnation flow vertical reactor using TBP and TBA" JOURNAL OF CRYSTAL GROWTH, NORTH-HOLLAND PUBLISHING CO. AMSTERDAM, NL, Bd. 195, Nr. 1-4, 15. Dezember 1998 (1998-12-15), Seiten 138-143, XP004154251 ISSN: 0022-0248
- WEYBURNE D W ET AL: "Design and operating considerations for a water-cooled close-spaced reactant injector in a production scale MOCVD reactor" JOURNAL OF CRYSTAL GROWTH, NORTH-HOLLAND PUBLISHING CO. AMSTERDAM, NL, Bd. 170, Nr. 1-4, 1997, Seiten 77-82, XP004087080 ISSN: 0022-0248

## Beschreibung

Die Erfindung betrifft ein Verfahren gemäß Gattungsbegriff des Anspruches 1.

Die WO93/17448 beschreibt eine Vorrichtung zur Durchführung eines derartigen Verfahrens. Innerhalb des Reaktorgehäuses befindet sich ein drehangetriebener Substrathalter. Dieser Substrathalter liegt in der Horizontalebene und ist um seine zentrale, in der Vertikalen liegenden Achse drehbar. In einem Abstand, der erheblich geringer ist als der Durchmesser des Substrathalters, befindet sich oberhalb des Substrathalters ein Gaseinlassorgan. An der auf den Substrathalter zuweisenden Seite des Gaseinlassorganes sind viele, siebartig angeordnete Gasaustrittsöffnungen vorgesehen. Diese, duschkopfartig ausgebildete Fläche bildet eine Gaseinlassfläche, durch welche das Prozessgas, das mittels einer Zuleitung dem Gaseinlassorgan zugeführt wird, in die Prozesskammer einströmen kann. Im Wesentlichen durch Diffusion gelangen die reaktiven Moleküle des Prozessgases zur Substratoberfläche. Wird in der Vorrichtung ein MOCVD-Prozess ausgeübt, so können sich die metallorganischen Ausgangsstoffe bzw. die Hydride innerhalb der Gasphase, nachdem sie die Gaseinlassfläche verlassen haben, zerlegen. Um eine Zerlegung vor den Austrittsöffnungen des Gaseinlassorganes zu verhindern, kann die Gaseinlassfläche gekühlt sein. Der Substrathalter wird von unten mittelst einer Heizeinrichtung geheizt. Bei dieser Heizeinrichtung kann es sich um eine Induktionsspule handeln, die mit Hochfrequenz betrieben wird.

Das Journal of Cristal Growth beschreibt in Band 195 (1998) auf den Seiten 725 - 732 anhand von Modellrechnungen angestellte theoretische Überlegungen, dass sich die Schichteigenschaften der auf auf dem Substrathalter aufliegenden Substraten abgeschiedenen Schichten qualitativ verbessern lassen, wenn die Prozesskammerhöhe, also der Abstand der Substratauflagefläche von der Gaseinlassfläche vermindert wird. In diesem Beitrag werden die besten Ergebnisse in einem Bereich zwischen 16 und 25 mm vermutet. Diese Vermutungen gelten aber nur für bestimmte Prozessbedingungen wie beispielsweise die Art der reaktiven Gase, den Prozesskammerdruck und den Gesamtgasfluss.

Weiter sind aus den US 5,781,693, WO 99/42638 und den US 6,086,677, US 5,595,606, US 5,709,757 und US 5,422,139 unterschiedlich gestaltete Gaseinlassorgane unter anderem ebenfalls mit siebartig angeordneten Gasaustrittsöffnungen vorbekannt.

Der Erfindung liegt die Aufgabe zugrunde, das eingangs genannten Verfahren hinsichtlich der beeinflussbaren Prozessparameter zu erweitern.

Gelöst wird die Aufgabe durch die in den Ansprüchen angegebene Erfindung. Das im Anspruch 1 vorgeschlagene Verfahren sieht vor, dass die Prozesskammerhöhe während des Abscheidungsprozesses verändert wird.

Die Vorrichtung kann dabei Prozesskammerhöhen einnehmen, deren Werte niedriger als 75 mm, 60 mm, 50 mm, 40 mm, 35 mm, 30 mm, 25 mm, 20 mm, 16 mm oder niedriger als 11 mm sind.

Durch Betätigung eines dem Reaktorgehäuse zugeordneten Distanzierungsmittels kann die Prozesskammerhöhe variiert werden. Diese Variation der Prozesskammerhöhe ist insbesondere bei geschlossenem Reaktorgehäuse möglich. Die Variation erfolgt erfindungsgemäß auch in situ, das heißt während einer Prozesssequenz. Diese Möglichkeit der Variation der Prozesskammerhöhe bei geschlossenem Reaktorgehäuse erlaubt es, während eines Abscheidungsprozesses, beispielsweise zwischen zwei Prozessschritten, die Prozesskammerhöhe zu verändern. Hierdurch kann die Prozesskammerhöhe den jeweiligen anderen Prozessparametern angepasst werden. Handelt es sich beispielsweise um Prozessschritte, die bei verschiedenen Totaldrücken oder bei verschiedenen Totalgasflüssen durchgeführt werden müssen, so kann die Prozesskammerhöhe jedes Mal auf den für diese Parameter optimalen Wert eingestellt werden. Dasselbe gilt selbstverständlich auch für verschiedene Substrathaltertemperaturen. Durch die Variation der Prozesskammerhöhe kann der Isothermenverlauf oberhalb des Substrathalters optimiert werden. In einer Weiterbildung der Erfindung ist vorgesehen, dass der Substrathalter gegenüber dem Boden und/oder der Seitenwand des Reaktorgehäuses verlagerbar ist. Dies ist insbesondere dann von Vorteil, wenn das Reaktorgehäuse topfförmig ausgebildet ist. Der dadurch gebildete zylinderförmige Hohlraum ist mit einem Deckel verschließbar, an welchem das Gaseinlassorgan fest verbunden ist. Beim Öffnen des Reaktorgehäuses wird dann auch gleichzeitig die Prozesskammer geöffnet, die von oben be- und entladbar ist. Das Distanzierungsmittel kann dabei dem Boden und/ oder der Seitenwand des Reaktorgehäuses zugeordnet werden. So schlägt eine Variante der Erfindung vor, dass es sich bei dem Distanzierungsmittel um einen Spindeltrieb handelt. Dieser Spindeltrieb kann dem Boden des Reaktorgehäuses zugeordnet sein. Auf dem Boden kann ein von außen betätigbarer Spindelantrieb sitzen, der die Höhe des ausgespindelten Spindelkopfes einstellen kann. Dieser Spindelkopf unterstützt den Substrathalter bzw. eine den Substrathalter tragende Tragplatte. Von dieser Tragplatte kann auch ein Gasauslassring getragen werden, der die Prozesskammer ringartig umgibt und welcher einen Hohlraum ausbildet, der das aus der Prozesskammer abfließende Prozessgas sammelt. Hierzu weist der Gasauslassring zum Zentrum der Prozesskammer weisende Öffnungen auf. Es ist aber nicht nur von Vorteil, wenn der Gasauslassring zusammen mit dem Substrathalter höhenverlagert wird, sondern wenn auch das Heizelement zusammen mit dem Substrathalter höhenverlagert wird. Hierdurch ergibt sich immer eine gleichbleibende Heizleistungsübertragung auf den Substrathalter. Bei einer Variante der Erfindung ist vorgesehen, dass der Substrathalter gegebenenfalls zusammen mit der Heizvorrichtung und/ oder dem Gasauslassring von in Richtung der vom Deckel verschließbaren Reaktorgehäuseöffnung vorgespannten Federn getragen wird, und beim Schließen des Deckels durch dem Deckel zugeordnete einstellbare Distanzierungsmittel der Substrathalter höhenverlagert wird. Hierbei kann insbesondere die Wand des Reaktorgehäuses einen Anschlag ausbilden, gegen den der Substrathalter oder eine sich mit dem Substrathalter zusammen verlagerbare Tragplatte anstößt. Diese Ausgestaltung hat den Vorteil, dass der Substrathalter bei geöffnetem Reaktorgehäusedeckel immer das gleiche Höhenniveau einnimmt, so dass die Be- und Entladung des Reaktors vereinfacht wird. Hierzu kann dann ein Automat verwendet werden, der - unabhängig von der Höheneinstellung des Substrathalters während des Prozesses - immer dieselbe Substrathalterhöhe vorfindet.

Ausführungsbeispiele der Erfindung werden nachfolgend anhand beigefügter Zeichnungen erläutert. Es zeigen:
- Fig. 1: in grob schematisierter Darstellung ein erstes Ausführungsbeispiel der Erfindung, wobei das Distanzierungsmittel als Spindeltrieb ausgebildet ist,
- Fig. 2: ein zweites, ebenfalls grob schematisiert dargestelltes Ausführungsbeispiel, wobei das Distanzierungsmittel als Distanzring ausgebildet ist, welches fest am Deckel des Reaktorgehäuses angebracht ist und
- Fig. 3: ein drittes Ausführungsbeispiel, ebenfalls in grob schematisierter Darstellung, bei welchem das Distanzierungsmittel ebenfalls dem Deckel des Reaktorgehäuses zugeordnet ist und sich das Distanzierungsmittel von außerhalb des Reaktorgehäuses verstellen lässt.

Die in den Ausführungsbeispielen beschriebenen Vorrichtungen besitzen ein topfförmiges Reaktorgehäuse, welches aus einer den Reaktorinnenraum ringförmig umschließenden Seitenwand 2 und einem horizontalen Boden 3 besteht. Verschließbar ist das Reaktorgehäuse durch den Deckel 1. Durch den Deckel 1 führt eine Zuleitung 25 für die Prozessgase. Diese Zuleitung mündet in einem auf der Innenseite des Deckels 1 befestigten Hohlkörper, der ein Gaseinlassorgan 7 ausbildet. Durch nicht dargestellte Mittel ist das Gaseinlassorgan 7 fest mit dem Deckel 1 verbunden. Innerhalb des Hohlraumes des Gaseinlassorganes 7 befindet sich eine Gasverteilungsplatte 30, so dass das aus der Zuleitung 25 ausströmende Prozessgas in gleichmäßiger Verteilung durch die dem Boden des Gaseinlassorganes 7 zugeordnete, siebartig angeordnete Austrittsöffnungen 8 in die Prozesskammer 4 strömen kann. Der erwähnte Boden des Gaseinlassorganes 7 bildet mit seiner durch die Austrittsöffnungen 8 perforierten Oberfläche eine Gaseinlassfläche 10 aus, die der Substratauflagefläche 9 in gleichbleibendem Abstand H gegenüberliegt.

Die Substrathalterauflagefläche 9 wird von der Oberfläche eines insbesondere aus Graphit gefertigten Substrathalters 5 ausgebildet.

Dieser Substrathalter 5 ist mittelst einer Antriebswelle, die um die Drehachse 6 drehbar ist, drehantreibbar.

Unterhalb des Substrathalters 5 befindet sich eine mit der Bezugsziffer 17 gekennzeichnete Tragplatte. Diese Tragplatte 17 muss nicht massiv ausgebildet sein. Sie kann im Bereich des Substrathalters 5 auch Speichen besitzen. Jedenfalls ist sichergestellt, dass die vom Heizelement 15 abgegebene Energie den Substrathalter 5 aufheizt. In einer bevorzugten Ausgestaltung wird das Heizelement 15 von einer Hochfrequenzspule ausgebildet, die innerhalb des Substrathalters 5 durch Induktion von Wirbelströmen Wärme erzeugt, um den Substrathalter 5 auf Prozesstemperatur zu bringen.

Die Prozesskammer 4 ist von einem Gasauslassring 16 ringförmig umgeben. Dieser Gasauslassring 16 besitzt eine Vielzahl von Öffnungen 28, die sich etwa auf dem Niveau der Substrathalterauflagefläche befinden, so dass das durch die Austrittsöffnungen 8 in die Prozesskammer 4 eingetretene Gas nach entsprechenden Gasphasenreaktionen oder Oberflächenreaktionen auf den Substraten 29 aus der Prozesskammer 4 abgeführt werden kann. Dieser Gasauslassring 16 liegt in den Ausführungsbeispielen auf einer Tragplatte 17 auf. Auch das Heizelement 15 ist fest mit der Tragplatte 17 verbunden, so dass bei einer Höhenverlagerung der Tragplatte 17 nicht nur der Substrathalter 5 und der Gasauslassring 16, sondern auch das Heizelement 15 mitverlagert wird.

Die Ausführungsbeispiele zeigen beispielhaft einige verschiedenartig ausgebildete Distanzierungsmittel 11, um die Höhenlage des Substrathalters 5, insbesondere der Substratauflagefläche, also den Abstand H zwischen Substratauflagefläche und Gaseinlassfläche 10 zu variieren. In nicht dargestellten Varianten kann diese Distanzierung auch durch Axialverlagerung der Antriebswelle für den Substrathalter 5 oder durch anders gestaltete Antriebsorgane, beispielsweise durch Scherengetriebe, erfolgen.

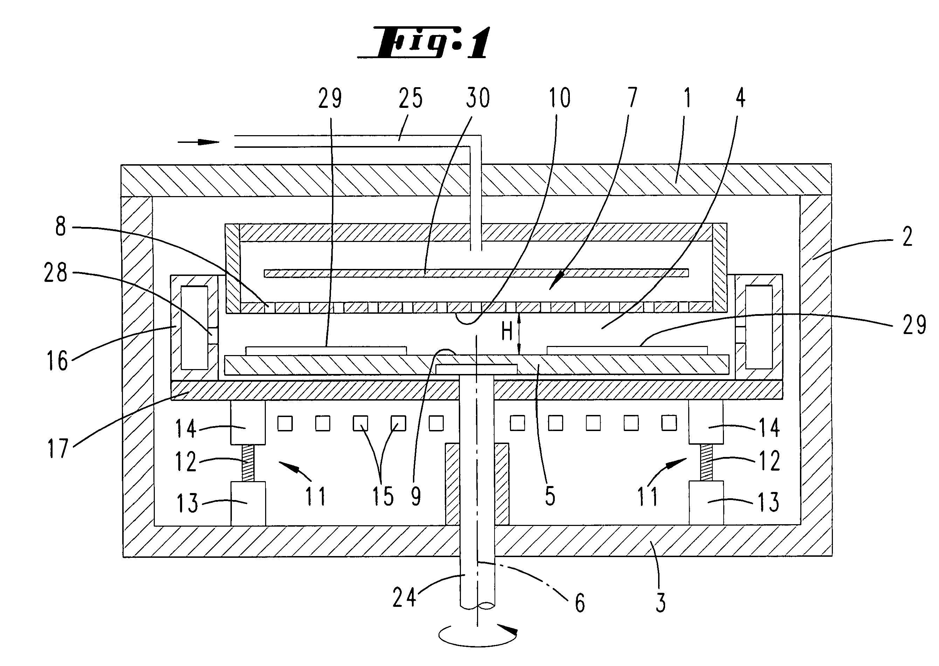

Bei dem in der Fig. 1 dargestellten Ausführungsbeispiel sitzen mehrere Spindelträger 13 auf dem Boden 3 des Reaktorgehäuses. In diesen Spindelträgern 13 sitzen von außen antreibbare oder elektrisch von einem dort angeordneten Motor antreibbare Spindelantriebsmotoren. Diese Spindelantriebsmotoren können eine Gewindespindel 12 antreiben, deren Spindelmutter in einem Spindellager 14 angeordnet ist, welches sich unterhalb der Tragplatte 17 befindet. Durch synchrones Drehen der Spindeln 12 kann somit das Niveau der Tragplatte 17 und somit der Abstand H (Prozesskammerhöhe) eingestellt werden. Der Gasauslassring 16 besitzt dabei eine Höhe, die so groß bemessen ist, dass der Gasauslassring 16 in allen einstellbaren Prozesskammerhöhen H die Prozesskammer seitlich hin begrenzt.

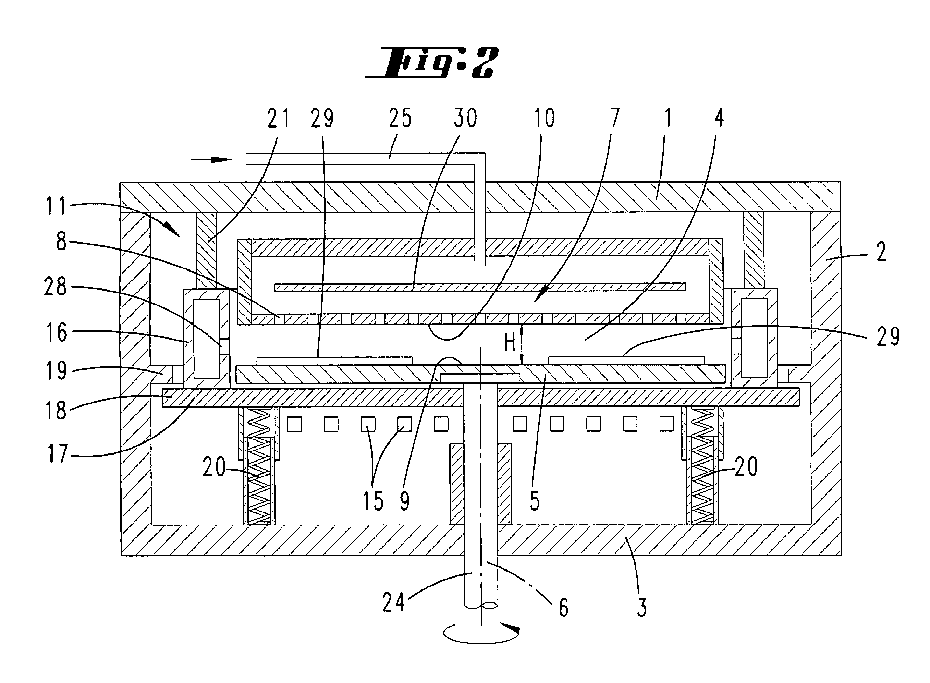

Bei dem in Fig. 2 dargestellten Ausführungsbeispiel ist die Tragplatte 17 bzw. der Substrathalter 5 auf Federn 20 gelagert, die sich auf dem Boden 3 des Reaktorgehäuses abstützen. Die Federn 20 sind in Richtung des Deckels 1 des Reaktorgehäuses vorgespannt. Die Tragplatte besitzt im Ausführungsbeispiel eine Anschlagschulter 18, die bei geöffnetem Reaktorgehäusedeckel 1 gegen einen Anschlag 19 der Reaktorgehäusewand 2 stößt. In dieser Position kann bei geöffnetem Reaktorgehäusedeckel 1 der Substrathalter 5 mit ein oder mehreren Substraten 29 be- oder entladen werden.

Auf der gehäuseeinwärts gerichteten Oberfläche des Deckels 1 des Reaktorgehäuses sitzt ein austauschbarer Distanzring 21. Die Breite des Ringes 21 kann verschieden gewählt sein und definiert die Prozesskammerhöhe H. Hierzu stützt sich der Distanzring 21 auf der Trägerplatte 17 bzw. auf dem von der Trägerplatte 17 gehaltenen Gasauslassring 16 ab und verlagert den Substrathalter 5 beim Schließen des Deckels 1 nach unten, so dass die Höhe H eingestellt wird.

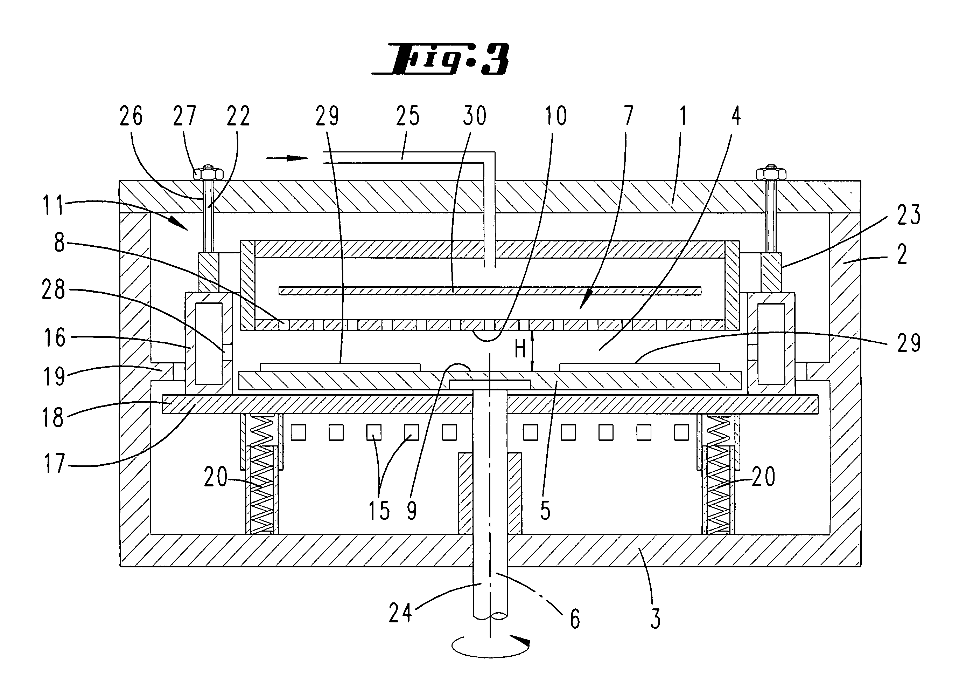

Bei dem in Fig. 3 dargestellten Ausführungsbeispiel sind die Distanzierungsmittel 11 ebenfalls dem Reaktorgehäusedeckel 1 zugeordnet. Bei diesem Ausführungsbeispiel können die Distanzierungsmittel 11 aber höhenverstellt werden. Die Fig. 3 zeigt eine einfachste Variante der Höheneinstellbarkeit, indem auf einen Druckring 23, der eine ähnliche Funktion besitzt wie der Distanzring 21, ein Gewindestift oder eine Gewindespindel 22 drückt. Dieser Gewindestift 22 kann in eine Gewindebohrung 26 des Reaktorgehäusedeckels 1 eingeschraubt werden. Durch Drehen des Gewindestiftes 22 kann die Höhenlage des Druckringes 23 bzw. die Prozesskammerhöhe H eingestellt werden. Fixiert wird die Drehstellung der Gewindestange 22 durch eine Kontermutter 27.

Es können mehrere derartiger Distanzierungsmittel 11 dem Reaktorgehäusedeckel 1 zugeordnet werden. Es ist insbesondere vorgesehen, dass diese Distanzierungsmittel 11 motorgesteuert werden. Es ist denkbar, dass die Gewindestangen 22 mit Spindelantrieben versehen werden, so dass während des Prozesses oder zumindest nach Schließen des Reaktorgehäuses die Prozesskammerhöhe H variiert werden kann.

Der Durchmesser des kreisrunden Substrathalters 5 kann mehr als 10 cm, mehr als 30 cm, mehr als 35 cm, mehr als 40 cm oder mehr als 45 cm betragen. Der Durchmesser des Substrathalters 5 entspricht im Wesentlichen dem Durchmesser der kreisrunden Gaseinlassfläche 10. Die Prozesskammerhöhe H ist wesentlich kleiner als der Durchmesser des Substrathalters 5 und kann weniger als 75 mm, weniger als 60 mm, weniger als 50 mm, weniger als 40 mm, weniger als 35 mm, weniger als 30 mm, weniger als 25 mm, weniger als 20 mm, weniger als 16 mm und sogar weniger als 11 mm betragen. Die Einstellung der Prozesskammerhöhe H kann während des Beschichtungsprozesses und insbesondere während einer Spülphase zwischen zwei Prozessschritten erfolgen. Als Verfahren zum Abscheiden dünner Schichten wird bevorzugt ein MOCVD-Verfahren verwendet, bei denen die Elemente der III-Hauptgruppe in Form von metallorganischen Verbindungen durch die Zuleitung 25 dem Gaseinlassorgan 7 zugeleitet werden. Die Elemente der V-Hauptgruppe werden als Hydride durch die Zuleitung 25 dem Gaseinlassorgan 7 zugeführt. Zufolge einer Kühlung des die Gasaustrittsöffnungen 8 umgebenden Bereichs der Bodenplatte des Gaseinlassorganes 7 wird eine Vorzerlegung dieser gasförmigen Ausgangsstoffe vermieden. Je nach Prozessparametern wie Totalgasfluss, Totaldruck und Drehzahl des Substrathalters kann die Prozesskammerhöhe eingestellt werden. Die Hubeinrichtung, die dem Reaktorgehäuse zugeordnet ist und mit welcher insbesondere das Gaseinlassorgan 7 oder der den Boden 3 bildende Substrathalter 5 verlagert werden kann, kann eine Ferrofluidcs-Hubeinrichtung sein. Eine derartige, Helium-Dichte Hubeinrichtung ist insbesondere geeignet, um in Z-Richtung zu wirken.

## Patentansprüche

1. Verfahren zum Abscheiden dünner Schichten auf ein Substrat in einer in einem Reaktorgehäuse (1, 2, 3) angeordneten Prozesskammer (4), deren Boden von einem temperierbaren Substrathalter (5), der um seine Vertikalachse (6) drehangetrieben wird, und deren Decke von einem Gaseinlassorgan (7) gebildet ist, wobei sich die Decke parallel zum Boden erstreckt und mit ihren siebartig angeordneten Gasaustrittsöffnungen (8) eine sich über die gesamte Substratauflagefläche (9) des Substrathalters (5) erstreckende Gasaustrittsfläche (10) ausbildet, durch welche das Prozessgas in die Prozesskammer (4) eingeleitet wird, und wobei die durch den Abstand (H) an der Substratauflagefläche (9) zur Gasaustrittsfläche (10) definierte Prozesskammerhöhe veränderbar ist, **dadurch gekennzeichnet, dass** der Abstand (H) einhergehend mit einer Änderung des Totalgasflusses bzw. Totaldrucks in der Prozesskammer (4) während des Abscheidungsprozesses variiert wird.

2. Verfahren nach Anspruch 1, **dadurch gekennzeichnet, dass** der Substrathalter (5) zusammen mit der Heizeinrichtung (15) höhenverlagert wird.

## Claims

1. Process for depositing thin layers on a substrate in a process chamber (4) which is disposed in a reactor housing (1, 2, 3) and the base of which is formed by a temperature-controllable substrate holder (5) that is driven in rotation about its vertical axis (6) and the cover of which is formed by a gas inlet member (7), the cover extending parallel to the base and forming, by means of its gas outlet openings (8), which are disposed in the manner of a sieve, a gas outlet surface (10) which extends over the entire substrate support surface (9) of the substrate holder (5) and through which the process gas is introduced into the process chamber (4), and whereby the process chamber height, which is defined by the spacing (H) between the substrate support surface (9) and the gas outlet surface (10) can be changed, **characterized in that** the spacing (H) is varied together with the change of the total gas flow or total treasure respectively in the process chamber (4) during the deposition process.

2. Process according to claim 1, **characterized in that** the substrate holder (5) is displaced vertically together with the heating device (15).

## Revendications

1. Procédé pour déposer des couches minces sur un substrat dans une chambre de traitement (4) agencée dans un logement de réacteur (1, 2, 3) dont le fond est constitué par un support de substrat à température réglable (5) qui peut être entraîné en rotation autour de son axe vertical (6) et dont le couvercle est constitué par un organe d'admission de gaz (7), étant entendu que le couvercle s'étend parallèlement au fond et forme, avec ses ouvertures (8) de sortie de gaz agencées à la manière d'un tamis, une surface de sortie de gaz (10) s'étendant sur toute la surface de contact avec le substrat (9) du support de substrat (5), à travers laquelle le gaz de traitement est introduit dans la chambre de traitement (4), et la hauteur de la chambre de traitement, définie par la distance (H) entre la surface de contact avec le substrat (9) et la surface de sortie de gaz (10), pouvant être modifiée, **caractérisé en ce que** la distance (H) varie en fonction d'une modification du flux total de gaz ou respectivement de la pression totale dans la chambre de traitement (4) pendant le processus de dépôt.

2. Procédé selon la revendication 1, **caractérisé en ce que** le support de substrat (5) est monté en hauteur en conjonction avec le dispositif de chauffage (15).
